# EUROPEAN PATENT APPLICATION

(11) **EP 2 998 152 A1**
(43) Date of publication of application: **23.03.2016**
(21) Application number: 15178590.4
(22) Date of filing: 28.07.2015
(51) Int. Cl.: B60L 11/18, G01R 15/04

(54) **CABLE INSTALLMENT TYPE CHARGING CONTROL DEVICE AND METHOD OF OPERATING THE SAME**

(30) Priority: 18.09.2014 KR 20140124514
(71) Applicant: LSIS Co., Ltd., Anyang-si, Gyeonggi-do 431-848 (KR)
(72) Inventor: KIM, Yong Woo, 431-848 Anyang-si, Gyeonggi-do (KR)
(74) Representative: Lang, Johannes

(57) **Abstract**

Provided is a plug of a grid-side power cable assembly connected to a cable installment type charging control device for charging an electric vehicle (EV) by using power of a grid-side. An exclusive socket detecting part detects whether a socket connected to the plug is an exclusive socket for the plug. A normal operation signal generating part generates a signal notifying whether the exclusive socket is detected. A voltage dividing part outputs a voltage so that an output voltage in a case in which the grid-side assembly is short-circuited is different from that of the grid-side power cable assembly in a case in which the signal is generated.

## Description

### FIELD OF THE INVENTION

The present disclosure relates to charging of an electric vehicle.

### BACKGROUND

The electric vehicle refers to a vehicle driven by using electricity, and is mainly classified into a battery powered electric vehicle and a hybrid electric vehicle. The battery powered electric vehicle is driven by using only electricity without fossil fuel, which is generally called an electric vehicle. In addition, the hybrid electric vehicle is driven by using both of the electricity and the fossil fuel. In addition, the electric vehicle is equipped with a battery to supply electricity for driving. In particular, the battery powered electric vehicle and a plug-in type hybrid electric vehicle have batteries charged with power supplied from an external power supply, and drive an electric motor by using the power charged in the battery.

When the electric vehicle is charged with 60 Hz-commercial grid power supplied through a household socket, an electric vehicle charging cable assembly is used.

The electric vehicle charging cable assembly includes a connector connected to the electric vehicle, a plug connected with the socket, and a power cable to link the connector to the plug.

Since the electric vehicle charging cable assembly is used under various environments, a cable installment type charging control device to ensure the stable charging of the electric vehicle may be provided in the electric vehicle charging cable assembly. The cable installment type charging control device is integrally attached to the power cable so that the cable installment type charging control device is not easily separated from the power cable by a user. In order to ensure the stable charging of the electric vehicle, the cable installment type charging control device is necessary to be strong against an external temperature, external humidity, vibration, and impact.

Meanwhile, the cable installment type charging control device includes a power relay for controlling power transfer blockage to control the charging of the electric vehicle.

However, since large power is applied to the power relay, the power relay may be fused. When the power relay is fused, it is impossible to control the charging of the electric vehicle, and thus the cable installment type charging control device has to determine whether the power relay is fused.

### SUMMARY

Embodiments provide a cable installment type charging control device that is capable of easily determining whether a power relay is fused and a method of operating the same.

In one embodiment, a plug of a grid-side power cable assembly connected to a cable installment type charging control device for charging an electric vehicle (EV) by using power of a grid-side includes: an exclusive socket detecting part for detecting whether a socket connected to the plug is an exclusive socket for the plug; a normal operation signal generating part for generating a signal notifying whether the exclusive socket is detected; and a voltage dividing part for outputting a voltage so that an output voltage in a case in which the grid-side power cable assembly is short-circuited is different from that of the grid-side power cable assembly in a case in which the signal is generated.

The normal operation signal generating part may include a switch having one end that is grounded, and the switch may be turned on based on whether the exclusive socket is detected.

The voltage dividing part may include a resistor connected to the other end of the switch.

The exclusive socket detecting part may include a magnetic sensor for detecting magnetic fields to detect the exclusive socket on the basis of the detected magnetic fields.

The exclusive socket detecting part may detect the exclusive socket on the basis of polarity and intensity of the magnetic fields.

In another embodiment, a plug of a grid-side power cable assembly connected to a cable installment type charging control device for charging an electric vehicle (EV) by using power of a grid-side includes: an exclusive socket detecting part for detecting whether a socket connected to the plug is an exclusive socket for the plug; a switch having one end that is grounded and turned on based on whether the exclusive socket is detected; and a first resistor having one end connected to the other end of the switch.

In further another embodiment, a method of operating a plug of a grid-side power cable assembly connected to a cable installment type charging control device for charging an electric vehicle (EV) by using power of a grid-side includes: detecting whether a socket connected to the plug is an exclusive socket for the plug through a normal operation signal generating part; generating a signal notifying whether the exclusive socket is detected through the normal operation signal generating part; and outputting a voltage through a voltage dividing part so that an output voltage value in a case in which the grid-side power cable assembly is short-circuited is different from that of the grid-side power cable assembly in a case in which the signal is generated.

### BRIEF DESCRIPTION OF THE DRAWINGS

Fig. 1 is a conceptual diagram of an electric vehicle charging system according to an embodiment.
Fig. 2 is a block diagram of an electric vehicle according to an embodiment.
Fig. 3 is a block diagram of an electric vehicle charging cable assembly according to an embodiment.
Fig. 4 is a block diagram of a detection unit according to an embodiment.
Fig. 5 is a block diagram of a terminal device according to an embodiment.
Fig. 6 is a ladder diagram showing an operation method of electric vehicle charging system according to an embodiment.
Fig. 7 is a block diagram of a grid-side power cable assembly including a plug according to an embodiment.
Fig. 8 is a block diagram of a detection unit of a cable installment type charging control device according to an embodiment.
Fig. 9 is a circuit diagram showing a state in which the plug is connected to the cable installment type charging control device according to an embodiment.
Fig. 10 is a flowchart showing a method in which the cable installment type charging control device determines whether the grid-side power cable assembly normally operates by using the plug according to an embodiment.
Fig. 11 is a block diagram of a grid-side power cable assembly including a plug according to another embodiment.
Fig. 12 is a circuit diagram showing a state in which the plug is connected to a cable installment type charging control device according to another embodiment.
Fig. 13 is a flowchart showing a method in which the cable installment type charging control device determines whether the grid-side power cable assembly normally operates by using the plug according to another embodiment.

### DETAILED DESCRIPTION OF THE EMBODIMENTS

Reference will now be made in detail to the embodiments of the present disclosure, examples of which are illustrated in the accompanying drawings.

In the following description, usage of suffixes such as 'module', 'part' or 'unit' used for referring to elements is given merely to facilitate explanation of the present invention, without having any discriminated meaning or role by itself.

A mobile terminal device according to the embodiment may include a cellular phone, a smart phone, a laptop computer, a digital broadcasting receiver, Personal Digital Assistants (PDA), Portable Multimedia Player (PMP), and a navigation device. It may be easily understood by those skilled in the art that the configuration disclosed through the embodiment is applicable to a stationary terminal such as a digital TV or a desktop computer, excluding a case of being applicable only to a mobile terminal.

Hereinafter, description about a first embodiment of an electric vehicle charging system is provided with reference to the accompanying drawings.

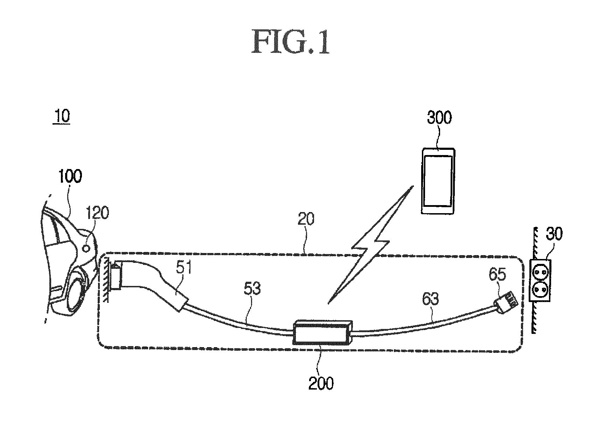

Fig. 1 is a conceptual diagram of an electric vehicle charging system according to an embodiment.

Referring to Fig. 1, an electric vehicle charging system 10 according to an embodiment includes an electric vehicle 100, an electric vehicle charging cable assembly 20, a socket 30, and a terminal device 300.

The socket 30 provides AC power supplied from a grid.

The electric vehicle 100 is connected to the socket 30 through the electric vehicle charging cable assembly 20 and receives the AC power from the socket 30.

The electric vehicle charging cable assembly 20 delivers AC power from the socket 30 to the electric vehicle 100.

The electric vehicle charging cable assembly 20 includes cable installment type charging control device 200, an electric vehicle connector 51, an electric vehicle (EV)-side power cable 53, a plug 65, and a grid-side power cable 63.

The EV-side power cable 53 and the grid-side power cable 63 deliver power.

The electric vehicle connector 51 is inserted into an electric vehicle inlet 120 and connected to the electric vehicle inlet 120, and may adhere to SAE J1772 specification.

The plug 65 is inserted and connected to the socket 30.

The cable installment type charging control device 200 monitors charging the electric vehicle 100, provides charging related information obtained through the monitoring to the terminal device 300, and controls charging of the electric vehicle 100.

In particular, the cable installment type charging control device 200 is integrally attached to the power cable 53 in order not to be easily separated from the EV-side power cable by the user. The cable installment type charging control device 200 have characteristics robust to an external temperature, external humidity, vibration, or impact.

In an embodiment, the cable installment type charging control device 200 may include a connector so as to be connected to or separated from the EV-side power cable 53 by the user. At this point, the connector is necessary to have characteristics robust to an external temperature, external humidity, vibration, or impact.

In an embodiment, the cable installment type charging control device 200 may be integrally attached to the grid-side power cable 63 so as not to be separated from the grid-side power cable 63 by the user. At this point, the connector has characteristics robust to an external temperature, external humidity, vibration, or impact.

In an embodiment, the cable installment type charging control device 200 may include a connector so as to be connected to or separated from the grid-side power cable 63 by the user. At this point, the connector is necessary to have characteristics robust to an external temperature, external humidity, vibration, or impact.

When the cable installment type charging control device 200 includes a connector for wired communication, since this connector includes a metal port, the cable installment type charging control device 200 may be weak to external environments. In order to address such an issue, the cable installment type charging control device 200 may wirelessly transmit charging related information to the terminal device 300.

The terminal device 300 wirelessly communicates in a non-contact scheme with the electric vehicle charging cable assembly 20 and displays information related to the electric vehicle charging cable assembly 20.

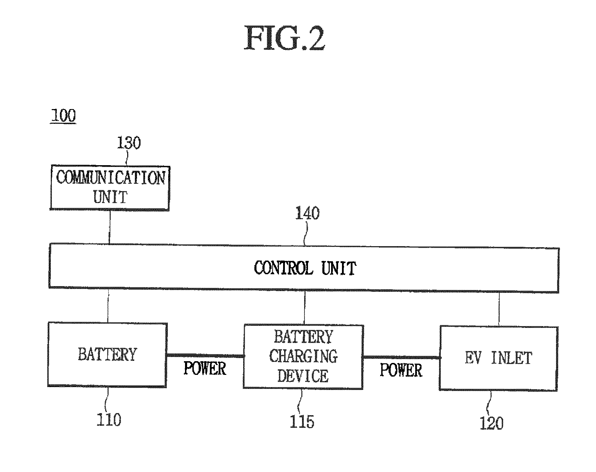

Fig. 2 is a block diagram of an electric vehicle according to an embodiment.

The electric vehicle 100 includes a battery 110, a battery charging device 115, an electric vehicle inlet 120, a communication unit 130, and a control unit 140.

The battery 110 provides power for driving the electric vehicle 100 to the electric vehicle 100.

The electric vehicle inlet 120 is a connector for receiving power for charging of the battery 100 from outside. The electric vehicle inlet 120 may adhere to SAE J1772 specification.

The battery charging device 115 charges the battery 110 by using power provided through the electric vehicle inlet 120.

The communication unit 130 may communicate with the electric vehicle charging cable assembly 20 or the terminal device 300.

The control unit 140 controls an overall operation of the electric vehicle 100.

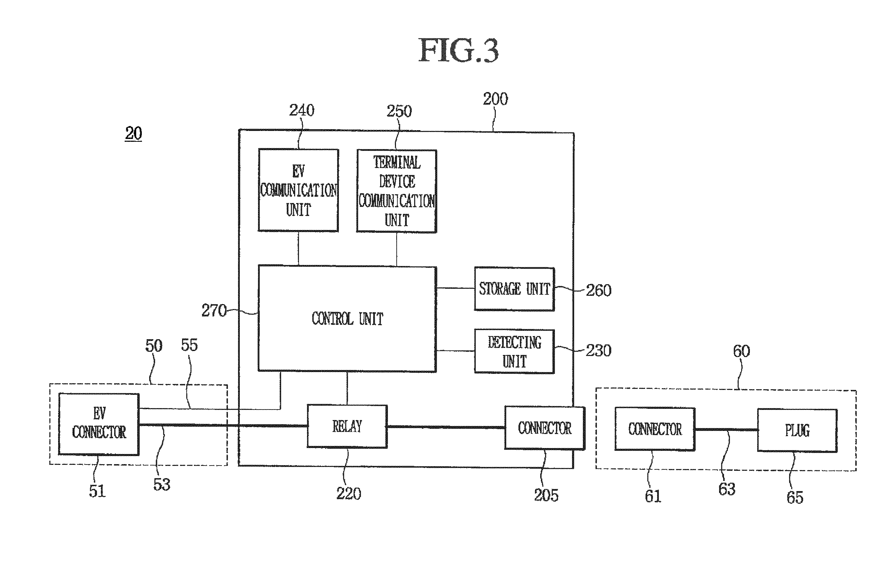

Fig. 3 is a block diagram of an electric vehicle charging cable assembly according to an embodiment.

The electric vehicle charging cable assembly 20 includes a cable installment type charging control device 200, an electric vehicle (EV)-side power cable assembly 50, and a grid-side power cable assembly 60.

Hereinafter, each of the EV-side power cable assembly 50 and the grid-side power cable assembly 60 may be called sub cable assembly.

The EV-side power cable assembly 50 includes the electric vehicle connector 51, the EV-side power cable 53, and an EV-side data communication cable 55.

The grid-side power cable assembly 60 includes a connector 61, the grid-side power cable 63, and the plug 65.

The cable installment type charging control device 200 includes a connector 205, a relay 220, a detecting unit 230, an electric vehicle communication unit 240, a terminal device communication unit 250, a storage unit 260, and a control unit 270.

The connector 205 may be coupled to the connector 61. The connector 205 may support coupling and separation with respect to the connector 61. That is, the connector 205 may be coupled to or separated from the connector 61.

The relay 220 controls to connect the EV-side power cable 53 to the grid-side power cable 63. In detail, when the relay 220 is turned off, the relay 220 disconnects the EV-side power cable 53 from the grid-side power cable 63. When the relay 220 is turned on, the relay 220 may electrically connect the EV-side power cable 53 to the grid-side power cable 63.

The detecting unit 230 detects information related to charging of the electric vehicle to be described later. In particular, the detecting unit 230 may detect all information on the electric vehicle 100 and information on the electric vehicle charging cable assembly 20. The detecting unit 230 may not detect information on the electric vehicle, but on the electric vehicle charging cable assembly 20.

The electric vehicle communication unit 240 performs communication with the electric vehicle 100. In detail, the electric vehicle communication unit 240 performs communication with the communication unit 130 of the electric vehicle 100. The electric vehicle communication unit 240 may perform communication with the communication unit 130 through the power cable 23 in a power-cable communication scheme. In addition, the electric vehicle communication unit 240 and the communication unit 130 may perform communication with each other through an infrared data association (IrDA) scheme, a radio frequency communication scheme, a Bluetooth scheme, an ultra wideband (UWB) scheme, a ZigBee scheme, and a digital living network alliance (DLNA) scheme.

The terminal device communication unit 250 performs communication with the terminal device 300. In detail, the terminal device communication unit 250 performs communication with a communication unit 310 of the terminal device 300. In particular, the terminal device communication unit 250 and the communication unit 310 may perform communication with each other through an IrDA scheme, a radio frequency communication scheme, a Bluetooth scheme, a UWB scheme, a ZigBee scheme, and a DLNA scheme.

The storage unit 260 stores various pieces of information to be described later. In detail, the storage unit 260 may store the charging related information on the electric vehicle 100. The storage unit 260 may store the information on the use history of the cable installment type charging control device 200. For example, the storage unit 260 may store the information on the final use time point, use time, and accumulated use time of the cable installment type charging control device 200.

The control unit 270 controls the overall operation of the cable installment type charging control device 200 together with the following operation.

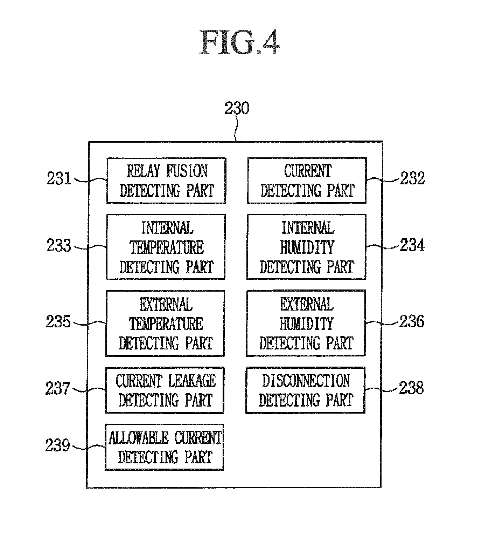

Fig. 4 is a block diagram of the detecting unit according to an embodiment.

As illustrated in Fig. 4, the detecting unit 230 may include a relay fusion detecting part 231, a current detecting part 232, an internal temperature detecting part 233, an internal humidity detecting part 234, an external temperature detecting part 235, an external humidity detecting part 236, a current leakage detecting part 237, a disconnection detecting part 238, and an allowable current detecting part 239.

The relay fusion detecting part 231 may detect whether the relay 220 is fused.

The current detecting part 232 may detect intensity of current flowing through the power cable 53.

The internal temperature detecting part 233 may detect an internal temperature of the electric vehicle charging cable assembly 20.

The internal humidity detecting part 234 may detect internal humidity of the electric vehicle charging cable assembly 20.

The external temperature detecting part 235 may detect a surrounding temperature of the cable installment type charging control device 200.

The external humidity detecting part 236 may detect surrounding humidity of the cable installment type charging control device 200.

The leakage detecting part 237 may detect whether current leaks from the electric vehicle charging cable assembly 20.

The disconnection detecting part 238 may detect whether the electric vehicle charging cable assembly 20 is disconnected.

The allowable current detecting part 239 may include a first allowable current detecting unit and a second allowable current detecting unit.

The first allowable current detecting unit may detect allowable current of the EV-side power cable assembly 50. In detail, the first allowable current detecting unit may detect allowable current of the EV-side power cable 53.

The second allowable current detecting unit may detect allowable current of the grid-side power cable assembly 60. In detail, the second allowable current detecting unit may detect allowable current of the grid-side power cable.

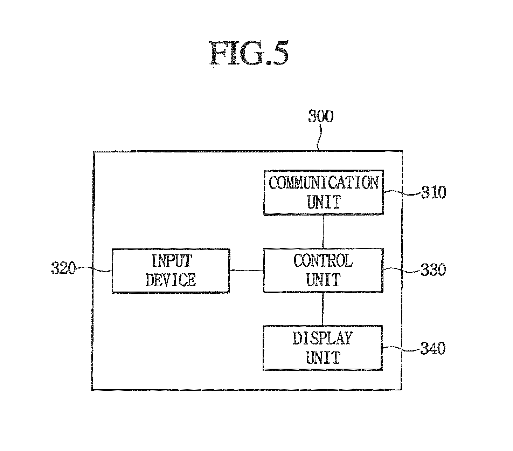

FIG. 5 is a block diagram of a terminal device according to one embodiment.

The terminal device 300 includes the communication unit 310, an input device 320, a control unit 330, and a display unit 340.

The communication unit 310 performs communication with the terminal device communication unit 250.

The input device 320 obtains a user input. The input device 320 may include at least one of a touch screen, a physical button, a microphone for obtaining the user input in a voice type, an acceleration sensor for obtaining a motion gesture of the terminal device 300 as the user input, a keyboard, a mouse, and a keypad.

The control unit 330 controls the overall operation of the terminal device 300 together with the following operation.

The display unit 340 displays information on the charging operation and a charging state of the cable installment type charging control device 200. The display unit 340 may display information on failure of the cable installment type charging control device 200 and information on action of a user dealing with the failure. For example, the display unit 340 may display information on the charging operation and the charging state of the cable installment type charging control device 200 through visually indicating manners including at least one of characters, geometrical figures, or light, and/or acoustically indicating manners including a sound.

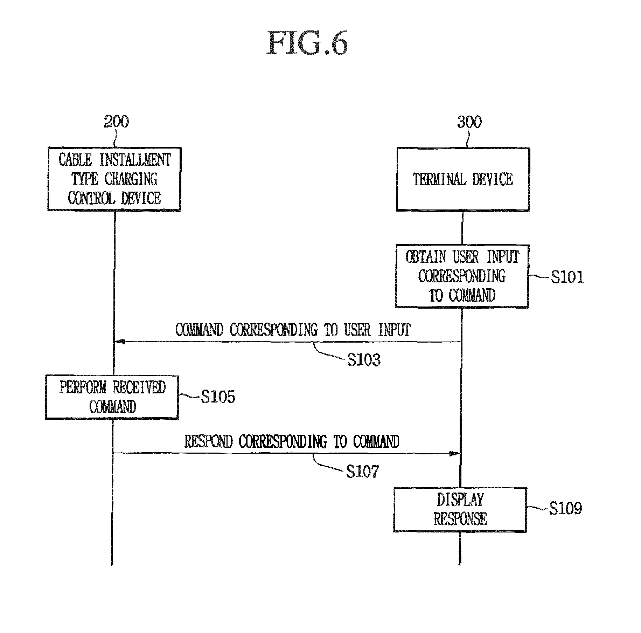

Fig. 6 is a ladder diagram showing an operation method of electric vehicle charging system according to an embodiment.

The control unit 330 of the terminal device 300 obtains the user input to issue a command to the electric vehicle charging cable assembly 20 through the input device 320 (operation S101). At this point, the user input for controlling the electric vehicle charging cable assembly 20 may include one or more of an input to start charging of the electric vehicle 100, an input to stop the charging of the electric vehicle 100, and an input to request the charging related information on the electric vehicle 100.

The control unit 330 of the terminal device 300 transmits a command corresponding to the obtained user input to the cable installment type charging control device 200 through the communication unit 310 (operation S103). The control unit 270 of the cable installment type charging control device 200 receives the command through the terminal device communication unit 250.

The control unit 270 of the cable installment type charging control device 200 executes the received command (operation S105).

In detail, when the command corresponding to the user input is a command to start the charging of the electric vehicle 100, the control unit 270 of the cable installment type charging control device 200 turns on the relay 220 that has been turned off, so that the electric vehicle charging cable assembly 20 may supply AC power to the electric vehicle 100 through the socket 30.

In more detail, when the command corresponding to the user input is a command to start the charging of the electric vehicle 100, the control unit 270 of the cable installment charging control device 200 may provide at least one of information with respect to allowable current of the EV-side power cable assembly 50 and information with respect to allowable current of the grid-side power cable assembly 60 to the battery charging device 115 of the electric vehicle 100 through the EV-side data communication cable 55. Also, the control unit 270 of the cable installment type charging control device 200 turns on the turned-off relay 220. Then, the battery charging device 115 of the electric vehicle 100 may determine charging current on the basis of the received information and bring the determined charging current through the electric vehicle charging cable assembly 20 to charge the battery 110.

When the control unit 270 provides information with respect to the allowable current of the EV-side power cable assembly 50, the battery charging device 115 of the electric vehicle 100 may charge the battery 110 by using current that is equal to or less than the allowable current.

When the control unit 270 provides information with respect to the allowable current of the grid-side power cable assembly 60, the battery charging device 115 of the electric vehicle 100 may charge the battery 110 by using current that is equal to or less than the allowable current.

When the control unit 270 provides information with respect to the allowable current of the EV-side power cable assembly 50 and information with respect to the allowable current of the grid-side power cable assembly 60, the battery charging device 1150 of the electric vehicle 100 may charge the battery 110 by using current that is equal to or less than the current having a relatively small value of the two allowable current.

When the command corresponding to the user input is a command to stop the charging of the electric vehicle 100, the control unit 270 of the cable installment type charging control device 200 turns off the relay 220, which has been turned on, to prevent the electric vehicle charging cable assembly 20 from charging the electric vehicle 100.

When the command corresponding to the user input is a command to request the charging related information on the electric vehicle 100, the control unit 270 of the cable installment type charging control device 200 collects the charging related information on the electric vehicle 100.

The control unit 270 of the cable installment type charging control device 200 transmits a response to the received command to the terminal device 300 through the terminal device communication unit 250 (operation S107).

When the command corresponding to the user input is the command to start the charging of the electric vehicle 100, the response may include information notifying that the relay 220 is in a turn-on state.

When the command corresponding to the user input is the command to stop the charging of the electric vehicle 100, the response may include information notifying that the relay 220 is in a turn-off state.

When the command corresponding to the user input is the command to request the charging related information on the electric vehicle 100, the response may include the collected charging related information on the electric vehicle 100.

The charging related information on the electric vehicle 100 may include at least one of information on the electric vehicle 100 and the information on the electric vehicle charging cable assembly 20.

The information on the electric vehicle 100 may include at least one of an initial charging state, a current charging state, a charging start time, an estimated charging finish time, an actual charging finish time, charging status information on the electric vehicle 100, charging error information on the electric vehicle 100, information on the power quantity supplied to the electric vehicle 100, and the information on amplitude of current applied to the electric vehicle 100. The initial charging state and the current charging state may be represented as a ratio of a current charged power quantity to the total capacity of the battery 110. The charging status information on the electric vehicle 100 may represent that the electric vehicle 100 is in the middle of being charged with power, in the standby state for charging, or has been completely charged.

The information on the electric vehicle charging cable assembly 20 may include at least one of information on the charging operation of the electric vehicle charging cable assembly 20, information on the use history of the electric vehicle charging cable assembly 20, state information on the electric vehicle charging cable assembly 20, information on the failure of the electric vehicle charging cable assembly 20, information on the allowable current of the EV-side power cable assembly 50, and information on the allowable current of the grid-side power cable assembly 60. The information on the charging operation of the electric vehicle charging cable assembly 20 represents whether the electric vehicle charging cable assembly 20 supplies the power, which is received through the socket 30, to the electric vehicle 100. The state information on the electric vehicle charging cable assembly 20 may include state information on the relay 220, the information on whether the relay 220 is fused, information on temperature of the electric vehicle charging cable assembly 20, information on the short-circuit of the electric vehicle charging cable assembly 20, information on disconnection of the electric vehicle charging cable assembly 20, and information on surrounding environments of the electric vehicle charging cable assembly 20. The state information on the relay 220 may represent whether the relay 220 is turned on or turned off. The information on the surrounding environments of the electric vehicle charging cable assembly 20 may include at least one of information on the surrounding temperature and information on the surrounding humidity.

The control unit 330 of the terminal device 300 displays the received response on the display unit 340 (operation S109).

When the command corresponding to the user input is a command for starting the charging of the electric vehicle 100, the control unit 330 of the terminal device 300 may display the information notifying that the relay 220 is in the turn-on state on the display unit 340.

When the command corresponding to the user input is a command for stopping the charging of the electric vehicle 100, the control unit 330 of the terminal device 300 may display the information notifying that the relay 220 is in the turn-off state on the display unit 340.

When the command corresponding to the user input is a command for requesting the charging related information on the electric vehicle 100, the control unit 330 of the terminal device 300 may display the charging related information on the electric vehicle 100 on the display unit 340. The user may input an additional user input for controlling the electric vehicle charging cable assembly 20, to the terminal device 300 through the input device 320 based on the displayed charging related information on the electric vehicle 100.

As described above, the information on the charging operation and the state information on the electric vehicle charging cable assembly 20 are displayed through the terminal device 300. Accordingly, the user may simply and easily recognize the information on the charging operation and the state information on the electric vehicle charging cable assembly 20. In addition, the user more easily determines the failure of the electric vehicle charging cable assembly 20 and the failed part of the electric vehicle charging cable assembly 20 based on the state information on the electric vehicle charging cable assembly 20, so that the user can easily take an action of dealing with the failure. For example, when the ground line is short-circuited between the electric vehicle charging cable assembly 20 and the power supply, the short-circuited ground line is difficult to detect according to the related art. However, according to the embodiment, the detecting unit 230 detects and displays the disconnection state, so that the user stops the charging of the electric vehicle charging cable assembly 20 and repairs the disconnected part or requests the repair for the disconnected part. In particular, when the information on the failure of the electric vehicle charging cable assembly 20 and the information on the action of dealing with the failure are transmitted to the terminal device 300 from the cable installment type charging control device 200, the user can more simply and easily detect the failure of the electric vehicle charging cable assembly 20 and take an action of dealing with the failure. Accordingly, the user can recognize in advance that the electric vehicle 100 is not charged due to the failure of the electric vehicle charging cable assembly 20. In addition, for example, if the use history of the electric vehicle charging cable assembly 20 is transmitted to the terminal device 300, the user can estimate in advance the life span of the electric vehicle charging cable assembly 20 and prepare an additional electric vehicle charging cable assembly.

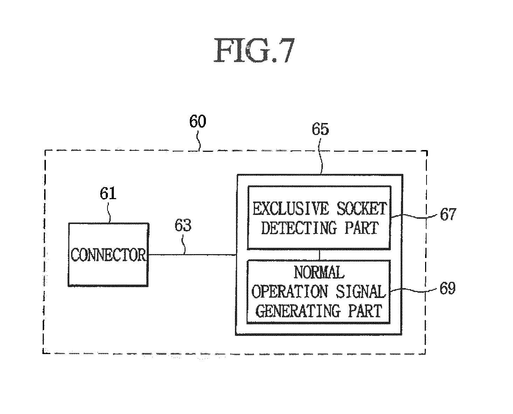

In general, the cable installment type charging control device 200 may charge the electric vehicle by using current higher than that used for the electronic product to rapidly charge the electric vehicle. For example, if intensity of the current used for the general electronic product is about 8 A, the cable installment type charging control device 200 may charge the electric vehicle by using current of about 16 A. However, to use this high current, stability of the socket for transmitting the current has to be ensured. Thus, an exclusive socket for high current may be used as the socket 30. Here, the cable installment type charging control device 200 needs to stop the charging operation when the socket 30 is not the exclusive socket. For this, the grid-side power cable assembly and the cable installment type charging control device 200 will be described with reference to Figs. 7 to 13.

Fig. 7 is a block diagram of a grid-side power cable assembly including a plug according to an embodiment.

The plug 65 according to an embodiment includes an exclusive socket detecting part 67 and a normal operation signal generating part 69.

The exclusive socket detecting part 67 may detect whether the socket 30 is the exclusive socket for the plug 65. In detail, the exclusive socket detecting part 67 may detect whether the exclusive socket is the exclusive socket that transmits the high current for charging the electric vehicle. In a detailed embodiment, the exclusive socket detecting part 67 may include a magnetic sensor. For example, the exclusive socket may include a magnetic body generating magnetic fields having a predetermined intensity, and the exclusive socket detecting part 67 may determine whether the socket 30 is the exclusive socket for the plug 65 by detecting the magnetic fields. Here, the exclusive socket detecting part 67 may determine whether the socket 30 is the exclusive socket for the plug 65 on the basis of the intensity and polarity of the magnetic fields. In detail, the exclusive socket detecting part 67 may determine the socket 30 as the exclusive socket when it is determined that magnetic fields having a certain polarity have intensity greater than a predetermined intensity.

The normal operation signal generating part 69 may generate a signal notifying information related to the socket 30 according to whether the socket 30 is the exclusive socket for the plug 65. In a detailed embodiment, the exclusive socket detecting part 67 may control the normal operation signal generating part 69. In a detailed embodiment, when the socket 30 is the exclusive socket for the plug 65, an internal circuit of the plug 65 connected to the connector 61 is grounded through the normal operation signal generating part 69. For example, the normal operation signal generating part 69 may be a switch having one end that is grounded.

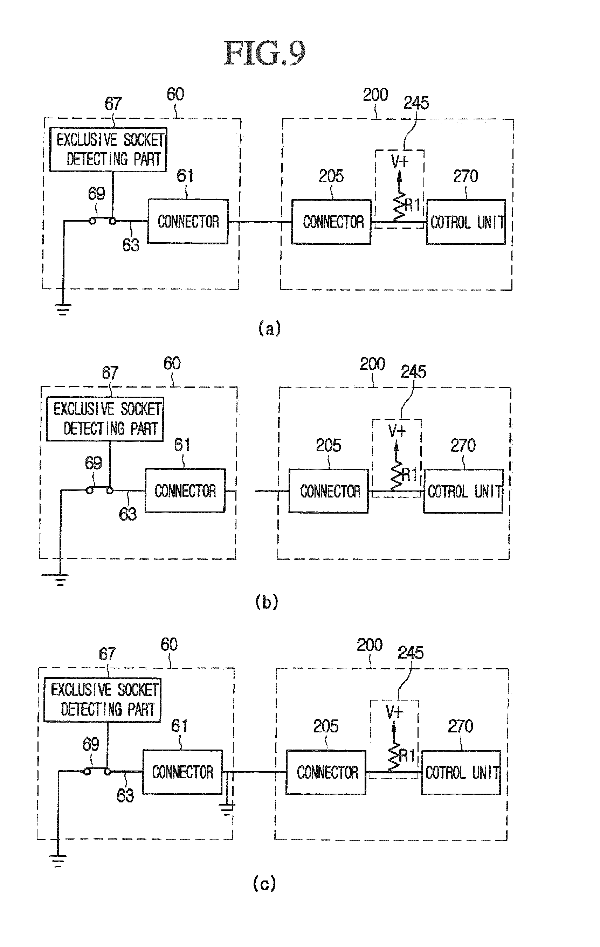

Detailed operations of the exclusive socket detecting part 67 and the normal operation signal generating part 69 according to an embodiment will be described with reference to Figs. 9 to 10.

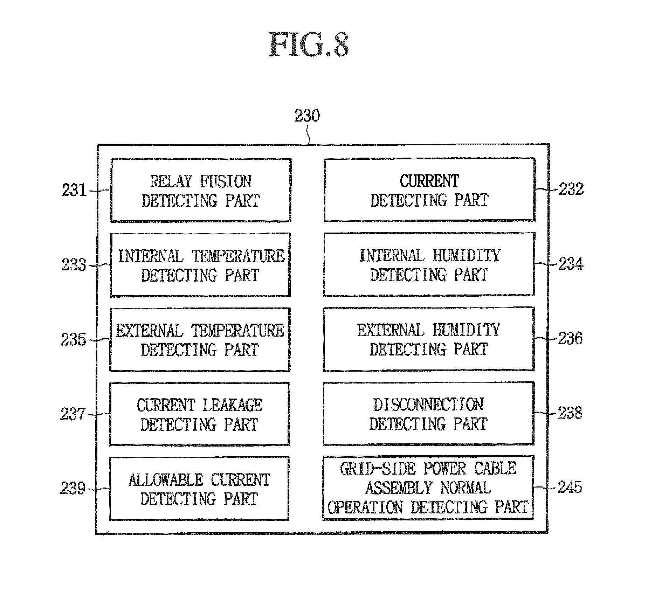

Fig. 8 is a block diagram of a detection unit of a cable installment type charging control device according to an embodiment.

The detecting unit 230 of the cable installment type charging control device 200 may include the grid-side power cable assembly normal operation detecting part as Fig. 8.

The grid-side power cable assembly normal operation detecting part 245 may detect whether the grid-side power cable assembly 60 normally operates. In particular, the grid-side power cable assembly normal operation detecting part 245 may detect whether the grid-side power cable assembly 60 is disconnected, or the socket 30 is determined as the exclusive socket for the plug 65.

Detailed operations of the grid-side power cable assembly normal operation detecting part 245 according to an embodiment will be described in detail with reference to Figs. 9 to 10.

Fig. 9 is a circuit diagram showing a state in which the plug is connected to the cable installment type charging control device according to an embodiment.

Fig. 9(a) shows a state in which the plug 65 is connected to the cable installment type charging control device 200 when the exclusive socket detecting part 67 detects the socket 30 as the exclusive socket, and the normal operation signal generating part 69 generates the normal operation signal.

The normal operation signal generating part 69 has one end that is grounded and the other end that is connected to one end of the connector 61.

The connector 61 has the other end that is connected to one end of the cable installment type charging control device 200. In detail, the other end of the connector 61 is connected to one end of the connector 205.

The other end of the connector 205 is connected to the grid-side power cable assembly normal operation detecting part 245. Here, the grid-side power cable assembly normal operation detecting part 245 may include a resistor R1 having one end to which a DC voltage is applied. Here, the resistor R1 has the other end that is connected to the control unit 270 and the connector 205.

In a detailed embodiment, the grid-side power cable assembly normal operation detecting part 245 may output the DC voltage to the control unit 270. In detail, the grid-side power cable assembly normal operation detecting part 245 may output the DC voltage applied to the resistor R1. Here, the DC voltage applied to the resistor R1 may vary in intensity according to whether the grid-side power cable assembly normal operation detecting part 245 normally operates. In detail, the DC voltage applied to the resistor R1 may vary in intensity according to the operation of the normal operation signal generating part 69 included in the grid-side power cable assembly normal operation detecting part 245. For example, when a switch included in the normal operation signal generating part 69 is turned off, a circuit in which the resistor R1 is included may be an open circuit. Thus, at this time, the voltage applied to the one end of the resistor R1 may be zero. Also, when the switch included in the normal operation signal generating part 69 is turned on, the circuit in which the resistor R1 is included may only include the resistor R1 as a resistance component. Thus, at this time, all of the DC voltage connected to the one end of the resistor R1 may be applied. However, it is assumed that the connector 61, the normal operation signal generating part 69, and the connector 205 do not ideally have the resistance components

Fig. 9(b) shows a state in which the plug 65 is connected to the cable installment type charging control device 200 when the grid-side power cable assembly 60 is disconnected even though the exclusive socket detecting part 67 detects the socket 30 as the exclusive socket, and the normal operation signal generating part 69 generates the normal operation signal.

In this case, the circuit in which the resistor R1 is included may be the open circuit like the case in which the switch included in the normal operation signal generating part 69 is turned off. Thus, the voltage applied to the one end of the resistor R1 may be zero.

Thus, when the voltage value outputted from the grid-side power cable assembly normal operation detecting part 245 is zero, it may be understood that the grid-side power cable assembly 60 is connected to a socket 30 that is not the exclusive socket or disconnected. The cable installment type charging control device 200 has to stop its operation to ensure safety in the case in which the grid-side power cable assembly 60 is connected to the socket 30 that is not the exclusive socket or disconnected. However, when the voltage value outputted from the grid-side power cable assembly normal operation detecting part 245 is zero, the control unit 270 may stop the charging operation.

Fig. 9(c) shows a state in which the plug 65 is connected to the cable installment type charging control device 200 when the grid-side power cable assembly 60 is short-circuited even though the exclusive socket detecting part 67 detects the socket 30 as the exclusive socket, and the normal operation signal generating part 69 generates the normal operation signal.

As an embodiment of Fig. 9(c), when the grid-side power cable assembly 60 is short-circuited, the one end of the connector 205 of the cable installment type charging control device 200 is grounded. In this case, like the case in which the switch included in the normal operation signal generating part 69 is turned on, the circuit in which the resistor R1 is included may only include the resistor R1 as the resistor component. Thus, all of the DC voltage connected to the resistor R1 may be applied to the one end of the resistor R1.

Thus, it is impossible for the control unit 270 to determine whether the grid-side power cable assembly is short-circuited, or the normal operation signal generating part 69 is turned on, through the voltage value outputted from the grid-side power cable assembly normal operation detecting part 245.

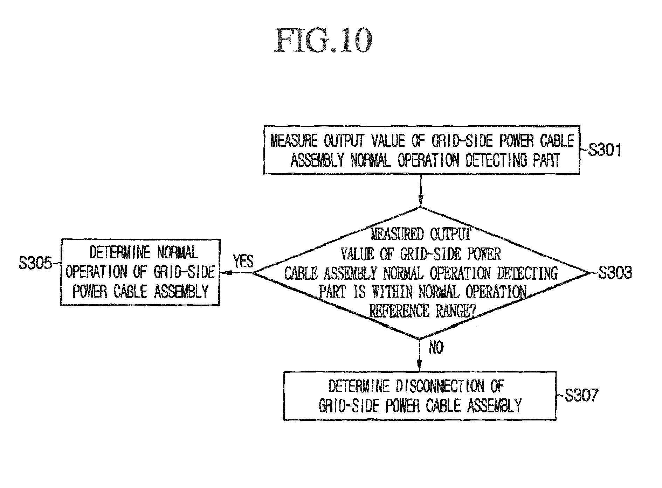

An operation method of the cable installment type charging control device 200 will be described in detail with reference to Fig. 10.

Fig. 10 is a flowchart showing a method in which the cable installment type charging control device determines whether the grid-side power cable assembly normally operates by using the plug according to an embodiment.

In operation S301, the control unit 270 measures an output value of the grid-side power cable assembly normal operation detecting part 245. In detail, the control unit 270 may measure an output voltage value of the grid-side power cable assembly normal operation detecting part 245.

In operation S303, the control unit 270 determines whether the measured voltage value is within a normal operation range. In detail, the control unit 270 may determine whether the measured voltage value is within a normal operation reference range. Here, the normal operation reference range may be determined on the basis of intensity of the DC voltage connected to the grid-side power cable assembly normal operation detecting part 245. For example, the normal operation reference range may be a range that is greater than about 0.9 times of intensity or equal to or less than intensity of the DC voltage connected to the grid-side power cable assembly normal operation detecting part 245.

When the measured voltage value is within the normal the normal operation reference, in operation S305, the control unit 270 determines that the grid-side power cable assembly normally operates.

When the measured output value of the grid-side power cable assembly normal operation detecting part 245 deviates from the normal operation reference range, in operation S307, the control unit 270 determines that the grid-side power cable assembly does not normally operate. Here, the control unit 270 may stop the operation of the cable installment type charging control device 200. Also, in a detailed embodiment, the control unit 270 may display the disconnection of the grid-side power cable assembly 60 to the outside through an LED.

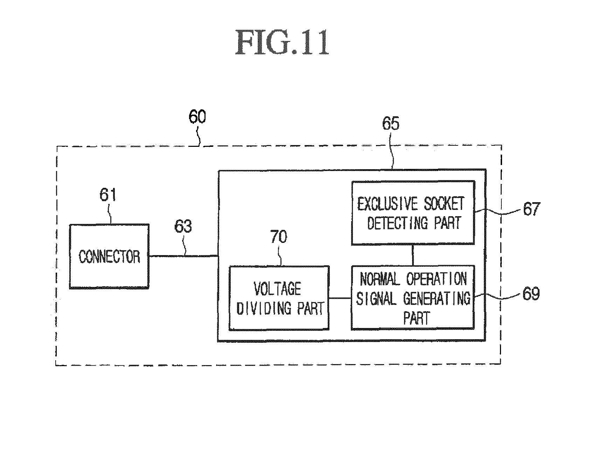

However, as described above, when the grid-side power cable assembly 60 is short-circuited, the one end of the connector 205 of the cable installment type charging control device 200 is grounded. Thus, the grid-side power cable assembly normal operation detecting part 245 may output values similar to each other in the case in which the grid-side power cable assembly 60 normally operates and in the case in which the grid-side power cable assembly 60 is short-circuited. Thus, a method for distinguishing a case in which the grid-side power cable assembly 60 normally operates from a case in which the grid-side power cable assembly 60 is short-circuited is necessary. In regards to this, it will be described with reference to Figs. 11 to 13.

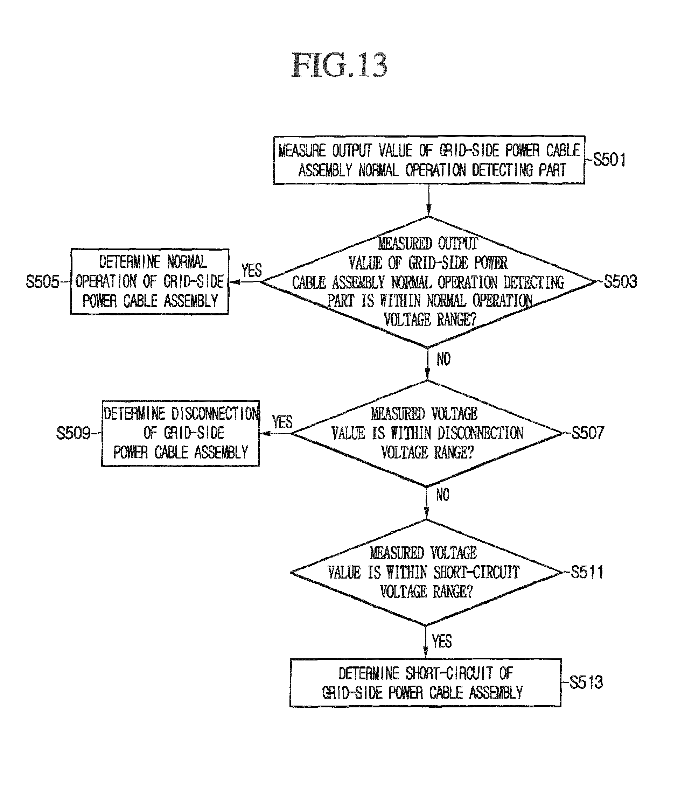

Hereinafter, a grid-side power cable assembly including a voltage dividing part and a cable installment type charging control device for determining whether the grid-side power cable normally operates will be described with reference to Fig. 13.

Fig. 11 is a block diagram of a grid-side power cable assembly including a plug according to another embodiment.

A plug according to another embodiment includes an exclusive socket detecting part 67, a normal operation signal detecting part 69, and a voltage dividing part 70.

Descriptions of the exclusive socket detecting part 67 and the normal operation signal generating part 69 will be the same as those of Fig. 7.

The voltage dividing part 70 may output a signal having a predetermined intensity when the normal operation signal generating part 69 generates a signal notifying that a socket 30 is the exclusive socket for a plug 65. In detail, when the internal circuit of the plug 65 connected to a connector 61 is grounded to allow the normal operation signal generating part 69 to generate the signal notifying that the socket 30 is the exclusive socket for the plug 65, the voltage dividing part 70 may output a voltage having a predetermined intensity. In a detailed embodiment, the voltage dividing part 70 may be a resistor. Thus, an output value of the grid-side power cable assembly 60 when the grid-side power cable assembly 60 is short-circuited may be different from that of the grid-side power cable assembly 60 when the normal operation signal generating part 69 generates the signal notifying that the socket 30 is the exclusive socket for the plug 65.

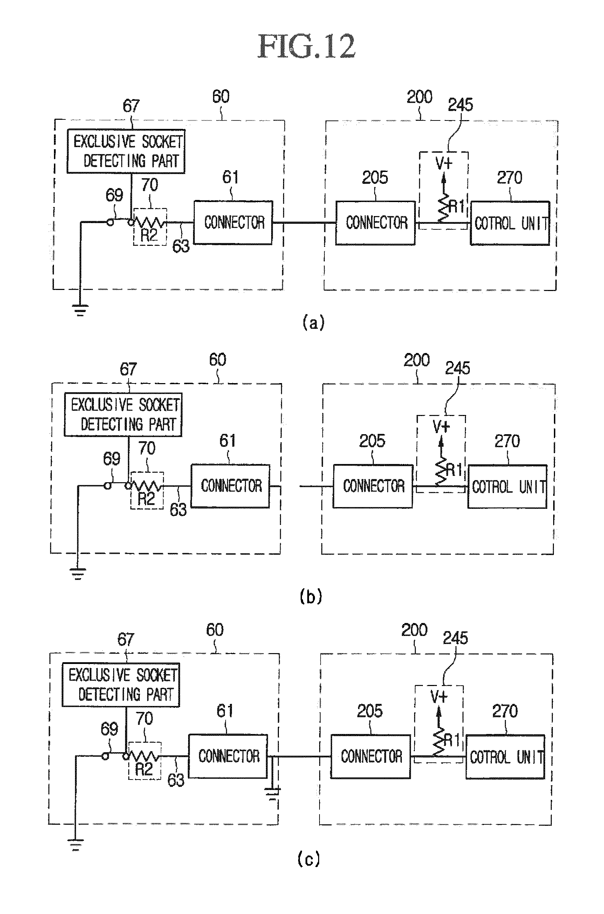

Detailed operations of the exclusive socket detecting part 67 and the normal operation signal generating part 69 according to an embodiment will be described in detail with reference to Figs. 12 to 13.

Fig. 12 is a circuit diagram showing a state in which the plug is connected to a cable installment type charging control device according to another embodiment.

Fig. 12(a) shows a state in which the plug 65 is connected to the cable installment type charging control device 200 when the exclusive socket detecting part 67 detects the socket 30 as the exclusive socket, and the normal operation signal generating part 67 generates a normal operation signal.

The normal operation signal generating part 69 has one end that is grounded and the other end that is connected to one end of the voltage dividing part 70.

The voltage dividing part 70 has the other end that is connected to one end of the connector 61. Here, the voltage dividing part 70 may be a resistor. In detail, the voltage dividing part 70 may be a resistor R2 having one end that is connected to the other end of the normal operation signal generating part 69 and the other end that is connected to the connector 61.

The connector 61 has the other end that is connected to one end of the cable installment type charging control device 200. In detail, the other end of the connector 61 is connected to one end of a connector 205.

The other end of the connector 205 is connected to a grid-side power cable assembly normal operation detecting part 245. Here, the grid-side power cable assembly normal operation detecting part 245 may include a resistor R1 having one end to which a DC voltage is applied. Here, the resistor R1 has the other end that is connected to a control unit 270 and the connector 205.

In a detailed embodiment, the grid-side power cable assembly normal operation detecting part 245 may output the DC voltage to the control unit 270. In detail, the grid-side power cable assembly normal operation detecting part 245 may output the DC voltage applied to the resistor R1. Here, the DC voltage applied to the resistor R1 have intensity that varies according to whether the grid-side power cable assembly normal operation detecting part 245 normally operates. In detail, the DC voltage applied to the resistor R1 may have intensity that varies according to an operation of the normal operation signal generating part 69 included in the grid-side power cable assembly normal operation detecting part 245. For example, when a switch included in the normal operation signal generating part 69 is turned off, a circuit in which the resistor R1 is included may be an open circuit. Thus, a voltage applied to the one end of the resistor R1 may be zero at this time. Also, when the switch included in the normal operation signal generating part 69 is turned on, and the voltage dividing part 70 includes the resistor R2, the circuit in which the resistor R1 is included may include the resistor R1 and the resistor R2 as resistor components. Thus, a voltage having intensity of R1/ (R1+R2) may be applied to the one end of the resistor R1. However, in this case, it is assumed that the connector 61, the normal operation signal generating part 69, and the connector 205 do not ideally have the resistor components.

Fig. 12(b) shows a state in which the plug 65 is connected to the cable installment type charging control device 200 in a case in which the exclusive socket detecting part 67 detects the socket 30 as the exclusive socket, and the grid-side power cable assembly 60 is disconnected although the normal operation signal generating part 69 generates the normal operation signal.

In this case, as the case in which the switch included in the normal operation signal generating part 69 is turned off, the circuit in which the resistor R1 is included may be an open circuit. Thus, a voltage applied to the one end of the resistor R1 may be zero.

Thus, when the voltage value outputted from the grid-side power cable assembly normal operation detecting part 245 is zero, it may be understood that the grid-side power cable assembly 60 is connected to a socket 30 that is not the exclusive socket or disconnected. The cable installment type charging control device 200 has to stop its operation to secure safety in the case in which the grid-side power cable assembly 60 is connected to the socket 30 that is not the exclusive socket or disconnected. Thus, when the voltage value outputted from the grid-side power cable assembly normal operation detecting part 245 is zero, the control unit 270 may stop the charging operation.

Fig. 12(c) shows a state in which the plug 65 is connected to the cable installment type charging control device 200 when the exclusive socket detecting part 67 detects the socket 30 as the exclusive socket, and the grid-side power cable assembly 60 is short-circuited although the normal operation signal generating part 69 generates the normal operation signal.

As illustrated in Fig. 12(c), when the grid-side power cable assembly 60 is short-circuited, the one end of the connector 205 of the cable installment type charging control device 200 is grounded. In this case, the circuit in which the resistor R1 is included may include only the resistor R1 as the resistor component. Thus, all of the DC voltages connected to the resistor R1 may be applied to the one end of the resistor R1.

Thus, unlike the embodiment of Figs. 7 to 11, the control unit 270 may determine whether the grid-side power cable assembly is short-circuited, or the normal operation signal generating part 69 is turned-on, through the voltage value outputted from the grid-side power cable assembly normal operation detecting part 245.

If intensity of the DC voltage connected to the resistor R1 is referred to as V, when the grid-side power cable assembly 60 normally operates, a voltage of V x R1/(R1+R2) may be applied to the one end of the resistor R1. Thus, if the resistor R2 has resistance that is excessively greater than that of the resistor R1, it may be difficult to distinguish an output value of the grid-side power cable assembly normal operation detecting part 245 when the grid-side power cable assembly 60 normally operates from an output value of the grid-side power cable assembly normal operation detecting part 245 when the grid-side power cable assembly 60 is disconnected or connected to the socket 30 that is not the exclusive socket. Also, if the resistor R2 has resistance that is excessively less than that of the resistor R1, it may be difficult to distinguish an output value of the grid-side power cable assembly normal operation detecting part 245 when the grid-side power cable assembly 60 normally operates from an output of the grid-side power cable assembly normal operation detecting part 245 when the grid-side power cable assembly 60 is disconnected. To solve these limitations, the resistor R1 may have the same resistance as that of the resistor R2 in the detailed embodiment. In the case in which the resistor R1 has the same resistance as that of the resistor R2 and in the case in which the grid-side power cable assembly 60 normally operates, the grid-side power cable assembly normal operation detecting part 245 may have an output value of V/2. Also, when the grid-side power cable assembly is short-circuited, the grid-side power cable assembly normal operation detecting part 245 has an output value of V. Also, when the grid-side power cable assembly 60 is disconnected or connected to the socket 30 that is not the exclusive socket, the grid-side power cable assembly normal operation detecting part 245 has an output value of zero. Thus, if the resistor R1 has the same resistance as that of the resistor R2, there is the biggest difference between output values of the grid-side power cable assembly normal operation detecting part 245 in a case in which when the grid-side power cable assembly 60 normally operates and in a case in which the grid-side power cable assembly 60 is disconnected or connected to the socket 30 that is not the exclusive socket. Therefore, when the resistor R1 has the same resistance as that of the resistor R2, a measurement value increases in reliability.

An operation method of the cable installment type charging control device 200 will be described in detail with reference to Fig. 13.

Fig. 13 is a flowchart showing a method in which the cable installment type charging control device determines whether the grid-side power cable assembly normally operates by using the plug according to another embodiment.

In operation S501, the control unit 270 measures an output value of the grid-side power cable assembly normal operation detecting part 245. In detail, the control unit 270 may measure an output voltage value of the grid-side power cable assembly normal operation detecting part 245.

In operation S503, the control unit 270 determines whether the measured voltage value is within a normal operation reference range. In detail, the control unit 270 may determine whether the measured voltage value is within the normal operation reference. Here, the normal operation reference range may be determined on the basis of the intensity of the DC voltage connected to the grid-side power cable assembly normal operation detecting part 245, the resistance value of the resistor R1 included in the grid-side power cable assembly normal operation detecting part 245, and the resistance value of the resistor R1 included in the voltage dividing part 70. For example, when the resistor R1 has the same resistance value as that of the resistor R2, the normal operation reference range may be greater than about 0.3 times of intensity or equal to or less than about 0.7 times of intensity of the DC voltage connected to the grid-side power cable assembly normal operation detecting part 245.

When the measured voltage value is within the normal operation reference range, in operation S505, the control unit 270 determines that the grid-side power cable assembly 60 normally operates.

When the measured voltage value deviates from the normal operation reference range, in operation S507, the control unit 270 determines whether the measured voltage value is within a disconnection reference range. The disconnection reference range may be determined on the basis of the intensity of the DC voltage connected to the grid-side power cable assembly normal operation detecting part 245, the resistance value of the resistor R1 included in the grid-side power cable assembly normal operation detecting part 245, and the resistance value of the resistor R2 included in the voltage dividing part 70. For example, when the resistor R1 has the same resistance value as that of resistor R2, the disconnection reference range may be less than about 0.1 times of intensity of the DC voltage connected to the grid-side power cable assembly normal operation detecting part 245 or equal to or greater than zero.

When the measured voltage value is within the disconnection reference range, in operation S509, the control unit 270 determines that the grid-side power cable assembly 60 is disconnected. Here, the control unit 270 may stop the operation of the cable installment type charging control device 200. Also, in a detailed embodiment, the control unit 270 may display the disconnection of the grid-side power cable assembly 60 to the outside through the LED.

When the measured voltage value deviates from the disconnection reference range, in operation S511, the control unit 270 determines whether the measured voltage value is within the short-circuit reference range. The disconnection reference range may be determined on the basis of the intensity of the DC voltage connected to the grid-side power cable assembly normal operation detecting part 245, the resistance value of the resistor R1 included in the grid-side power cable assembly normal operation detecting part 245, and the resistance value of the resistor R2 included in the voltage dividing part 70. For example, when the resistor R1 has the same resistance value as that of resistor R2, the disconnection reference range may be greater than about 0.9 times of intensity or equal to or less than intensity of the DC voltage connected to the grid-side power cable assembly normal operation detecting part 245.

When the measured voltage value is within the short-circuit reference range, in operation S513, the control unit 270 determines that the grid-side power cable assembly 60 is short-circuited. Here, the control unit 270 may stop the operation of the cable installment type charging control device 200. Also, in a detailed embodiment, the control unit 270 may display the disconnection of the grid-side power cable assembly 60 to the outside through the LED.

When the measured voltage value deviates from the short-circuit reference range, the control unit 270 returns to an initial stage to measure an output value of the grid-side power cable assembly normal operation detecting part 245. This is done because it is understood that the output value of the grid-side power cable assembly normal operation detecting part 245 changes due to noises and thus is not included in any one of the normal operation reference range, the disconnection reference range, and the short-circuit reference range.

Like this, the plug 65 of the grid-side power cable assembly 60 connected to the cable installment type charging control device 200 according to another embodiment may allow the cable installment type charging control device 200 to easily detect breakdown due to the disconnection of the grid-side power cable assembly and short-circuit. Thus, the cable installment type charging control device 200 may prevent fire and short-circuit from occurring to secure safety. Also, power waste of the cable installment type charging control device 200 may be prevented.

According to an embodiment, the above-described method can be embodied as processor readable codes on a program recorded medium. Examples of the processor readable recording medium include read-only memory (ROM), random-access memory (RAM), CD-ROMs, magnetic tapes, floppy disks, and optical data storage devices , and carrier waves (such as data transmission through the Internet).

Not only the configurations and methods of the embodiments are limitedly applied to the above-described mobile terminal, but also the whole embodiments or parts of the embodiments can be selectively combined and configured to allow various modifications to be conducted.

The plug of the grid-side power cable assembly connected to the cable installment type charging control device according to the embodiments may easily detect whether the socket connected to the plug is the exclusive socket for the plug.

Also, the plug of the grid-side power cable assembly connected to the cable installment type charging control device may allow the cable installment type charging control device to easily detect the breakdown due to the disconnection of the grid-side power cable assembly and short-circuit.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A plug (65) of a grid-side power cable assembly connected to a cable installment type charging control device (200) for charging an electric vehicle (EV) by using power of a grid-side, the plug comprising:
an exclusive socket detecting part (67) for detecting whether a socket connected to the plug (65) is an exclusive socket for the plug (65);
a normal operation signal generating part (69) for generating a signal notifying whether the exclusive socket is detected; and
a voltage dividing part (70) for outputting a voltage so that an output voltage in a case in which the grid-side power cable assembly is short-circuited is different from that of the grid-side power cable assembly in a case in which the signal is generated.

2. The plug (65) according to claim 1, wherein the normal operation signal generating part (69) comprises a switch having one end that is grounded, and
the switch is turned on based on whether the exclusive socket is detected.

3. The plug (65) according to claim 2, wherein the voltage dividing part (70) comprises a resistor connected to the other end of the switch.

4. The plug (65) according to claim 1, wherein the exclusive socket detecting part (67) comprises a magnetic sensor for detecting magnetic fields to detect the exclusive socket on the basis of the detected magnetic fields.

5. The plug (65) according to claim 4, wherein the exclusive socket detecting part (67) detects the exclusive socket on the basis of polarity and intensity of the magnetic fields.

6. A plug (65) of a grid-side power cable assembly connected to a cable installment type charging control device (200) for charging an electric vehicle (EV) by using power of a grid-side, the plug comprising:
an exclusive socket detecting part (67) for detecting whether a socket connected to the plug (65) is an exclusive socket for the plug (65);
a switch having one end that is grounded and turned on based on whether the exclusive socket is detected; and
a first resistor having one end connected to the other end of the switch.

7. The plug (65) according to claim 6, wherein the cable installment type charging control device (200) comprises a grid-side power cable assembly normal operation detecting part comprising a second resistor to determine whether the grid-side power cable assembly normally operates on the basis of intensity of a voltage applied to the second resistor, and
the first resistor has the same resistance as that of the second resistor.

8. A method of operating a plug of a grid-side power cable assembly connected to a cable installment type charging control device (200) for charging an electric vehicle (EV) by using power of a grid-side, the method comprising:
detecting whether a socket connected to the plug is an exclusive socket for the plug through a normal operation signal generating part (69);
generating a signal notifying whether the exclusive socket is detected through the normal operation signal generating part; and
outputting a voltage through a voltage dividing part (70) so that an output voltage value in a case in which the grid-side power cable assembly is short-circuited is different from that of the grid-side power cable assembly in a case in which the signal is generated.

9. The method according to claim 8, wherein the normal operation signal generating part (69) comprises a switch having one end that is grounded, and
the switch is turned on based on whether the exclusive socket is detected.

10. The method according to claim 9, wherein the voltage dividing part (70) comprises a resistor connected to the other end of the switch.

11. The method according to claim 8, wherein the detecting of the exclusive socket comprises:
detecting magnetic fields; and
detecting the exclusive socket on the basis of the detected magnetic fields.

12. The method according to claim 11, wherein the detecting of the exclusive socket on the basis of the detected magnetic fields comprises detecting the exclusive socket on the basis of polarity and intensity of the magnetic fields.
